(19) Europäisches Patentamt / European Patent Office / Office européen des brevets

(11) **EP 2 485 573 A1**

(12) **EUROPEAN PATENT APPLICATION**

(43) Date of publication:
**08.08.2012 Bulletin 2012/32**

(51) Int Cl.:
***H05K 9/00*** *(2006.01)*

(21) Application number: **12153632.0**

(22) Date of filing: **02.02.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME** | (71) Applicant: **Aeronautical Service S.r.l.**<br>**00054 Fiumicino (RM) (IT)**<br><br>(72) Inventor: **Bordignon, Cristiano**<br>**I-00054 FIUMICINO (RM) (IT)** |
| (30) Priority: **03.02.2011 IT RM20110050** | (74) Representative: **Fiammenghi, Eva et al**<br>**Fiammenghi - Fiammenghi**<br>**Via Quattro Fontane, 31**<br>**00184 Roma (IT)** |

(54) **Container box made of carbon fiber for electronic equipment**

(57)   A container made of carbon fiber for electronic or electromechanical equipment, for aeronautical and/or military use, comprising a laminate (8, 9, 10, 11) with layers of carbon fiber with thermosetting matrices, whose internal layer (8) - which faces the electronic or electromechanical equipment - is formed by a metal electromagnetic shielding film (8).

EP 2 485 573 A1

**Description**

Field of the art

The present invention generally refers to the military industry, to aeronautics, to the Formula 1 industry, and more generally to all those situations in which the electronic equipment must be shielded, in a container, in order to protect it from external electromagnetic waves, or in order to protect other electronic equipment, outside the container, from the electromagnetic waves emitted by the devices inside the container itself. More specifically, the invention also regards the containers which simultaneous carry out the function of protection (of the electronic equipment) from mechanical and thermal stresses, from oxidation and from fire.

State of the art

The containers of electronic or electromechanical equipment generally used on fixed wing or rotary wing aircraft, ship units, tanks, simple troop transport vehicles, must have the particular characteristic of shielding the electromagnetic emissions generated by the internal equipment so as to avoid affecting the correct functioning of other equipment set in said aircraft (and vice versa).

No device can be completely shielded, because openings are still necessary in order to make the passage for the connection and/or cooling cables: such openings, if made without the necessary expedients, risk ruining the shielding effect.

In general, the shielding efficiency is easier to estimate than precisely calculate, since it depends on many factors, including: the frequency of the irradiated field, the material used, the type of field (electric or magnetic), the distance between source, shield, receiver, as well as the nature of the discontinuities present on the shield.

The measure normally used for representing the insulation capacity of a shield is the so-called shielding efficiency.

This is calculated as the ratio between the intensity of the electromagnetic field measured without shield and that of the electromagnetic field with the shield present: the definition is applied both to the electric and magnetic field.

$$S_E = 20 Log\left(\frac{|E|_{FREE}}{|E|_{SHIELDED}}\right) \quad [dB]$$

$$S_H = 20 Log\left(\frac{|H|_{FREE}}{|H|_{SHIELDED}}\right) \quad [dB]$$

Quite often, the values for the electric field and the magnetic field are very different.

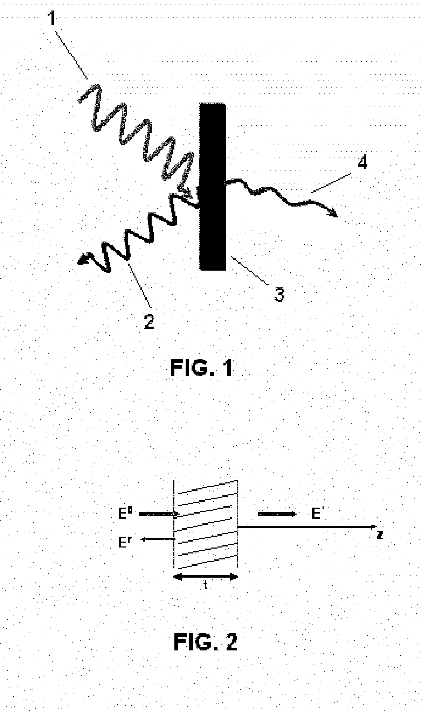

For a continuous shield of conductor material with finite thickness, the efficiency is given by the sum of three different contributions (see Fig. 1):

**S=A+R+B [dB] ≡ "Insertion loss" (coupling loss)**

Where 1 = incident wave, 2 = reflected wave, 3 = shield, 4 = transmitted wave;

**A** represents the attenuation due to the absorption losses,
**R** the losses due to reflection (which are the main mechanisms of electromagnetic field shielding).
**B** is a factor that accounts for multiple reflections and generally has sign opposite the first two; it is generally ignored.

**SHIELDING EFFICIENCY: losses due to absorption**

The absorption losses are essentially due to the skin effect: an electromagnetic field that is propagated through a conductor is attenuated due to the dissipation, which is due to the resistive properties of the conductor.

This effect ensures that the field is exponentially attenuated:

$$E \propto e^{-\frac{z}{\delta}} \quad [\text{V/m}]$$

where

$$\delta = \frac{1}{\sqrt{\pi f \mu \sigma}} \quad \textbf{depth of penetration} \quad [\text{m}]$$

$$\sigma = \textbf{electrical conductivity } [\text{S/m}]$$

$\delta$ is the depth of penetration of the field due to skin effect, and represents the distance under the surface of the conductor within which the field is attenuated by a factor e.

An electric field is propagated inside a conductor according to a law of exponential type (Fig. 2):

$$E = E_0 e^{-\frac{t}{\delta}} e^{-j\frac{t}{\delta}}$$

A wave with electric field E, hits (see Fig. 2) the shield with finite thickness t, and the wave reemerges on the other side (indicated here with E').

The problems connected with the surrounding conditions are ignored here (the continuity of the fields must be satisfied, etc.) and it is assumed that the entire incident wave is transmitted to the interface of thickness t.

The ratio between E' and E is defined "losses by absorption", and by considering the moduli of the electric field vectors one has

$$\frac{|E'|}{|E|} = \frac{E_0 e^{-\frac{t}{\delta}}}{E_0} \qquad where \qquad |E'| = \left| E_0 e^{-\frac{t}{\delta}} e^{-j\frac{t}{\delta}} \right| = E_0 e^{-\frac{t}{\delta}}$$

If the shield had an infinite thickness, nothing would reach the other side.

In reality, an infinite thickness does not make sense: consequently, if we are attempting to construct a shield, a part of the incident electric field will go beyond the shield, giving rise to a certain disturbance.

In order to quantify the shielding efficiency, the following formula is used:

$$A\,dB = 20 Log_{10} \frac{|E|}{|E'|} = 20 Log_{10} \left[ \frac{1}{e^{-\frac{t}{\delta}}} \right] = 20 Log_{10} \left[ e^{\frac{t}{\delta}} \right] = 20 \frac{t}{\delta} Log_{10} [e] = 8.686 \cdot \frac{t}{\delta}$$

The dB equation is linearly related to the thickness $t$ of the material. A "metal" shield attenuates 8.69 dB for each thickness equal to the depth of penetration. For example, a metal shield equal to $10\delta$ will have an attenuation via absorption equal to about 90 dB.

It is clear that in terms of natural numbers, the line will become exponential. Therefore, with the increase of the thickness $t$ of the material, the attenuation efficiency increases exponentially.

In addition to the phenomenon of proportionality with t, there is also the dependence on the frequency $f$:

$$\delta = \frac{1}{\sqrt{\pi f \mu \sigma}} \quad = \quad A\,dB = 8.686 \left[ t \sqrt{\pi f \mu \sigma} \right]$$

The attenuation expressed in dB is therefore proportional to the square root of the frequency *f* and to the root of the product μσ.

In order to underline the phenomenon of the dependence on the frequency *f*, we consider the following table, which reports the values of depth of penetration and absorption for an aluminum strip of 1 mm thickness and indefinite extension with the change in frequency.

It can be seen that at 50 Hz, the depth of penetration is 1.2 cm with the consequent attenuation entirely negligible, whereas already at 1 MHz the attenuation becomes extremely high (105 dB); consequently, one can conclude that the phenomenon of losses by absorption can be exploited for high frequency disturbances, for which a shield of very reduced thickness is sufficient.

| FREQUENCY | PENETRATION DEPTH | A |
|---|---|---|
| 50 Hz | 12 mm | 0.72 dB |
| 1 kHz | 2.7 mm | 3.2 dB |
| 1 MHz | 83 μm | 105 dB |
| 100 MHz | 8.3 μm | 1047 dB |

The other parameter on which the depth of penetration depends (i.e. the product between magnetic permeability and electric conductivity) is useful for determining which type of conductor material to employ for making the shield.

Clearly, the best material is that with the highest coefficient μσ, which does not necessarily coincide with the best conductor.

Analyzing two conductor materials such as Iron and Copper, one finds that Copper has a conductivity σ about 10 times greater than Iron, but Copper has a magnetic permeability μ about 1000 times less than Iron. Therefore, in conditions of non-magnetic saturation of iron, the root of the product μσ for Iron is about 10 times that of Copper.

Consequently, due to the skin effect, a copper shield of 1mm is equivalent to a ferromagnetic shield of 1/10 mm. In other words, given the same thickness one obtains absorption values that are ten times higher.

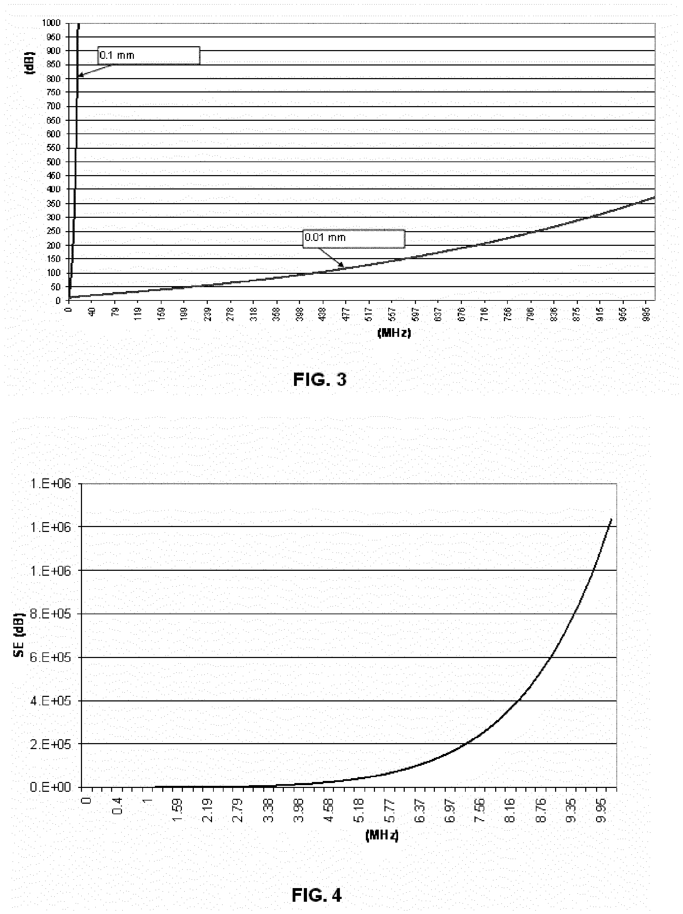

For example, using a thin aluminum plate, for 1/10 and 1/100 mm thicknesses, the values of shielding via skin effect are obtained and reported on the y-axis in Fig. 3, in dB, as a function of the frequency f (x-axis), in MHz.

If instead of aluminum, steel or iron is used, the shielding due to skin effect would be considerably higher, due to the magnetic permeability of iron which is about 1000 times that of aluminum. Therefore, already at low MHz frequencies, the shielding would be hundreds of dB (see Fig. 4, SE = shielding efficiency). X-axis = frequency (MHz).

**SHIELDING EFFICIENCY: losses via reflections**

The first step in the calculation of the losses by reflection is to determine the impedances involved, defined as the ratio between the intensity of the electric field and that of the magnetic field.

Such parameter depends both on the characteristics of the medium in which the wave is propagated and on the distance between the source and the observation point; it also depends on the type of source that one wishes to shield: comparable to electric dipole or to magnetic dipole.

$$\Gamma = \frac{Z_1 - Z_0}{Z_1 + Z_0}$$

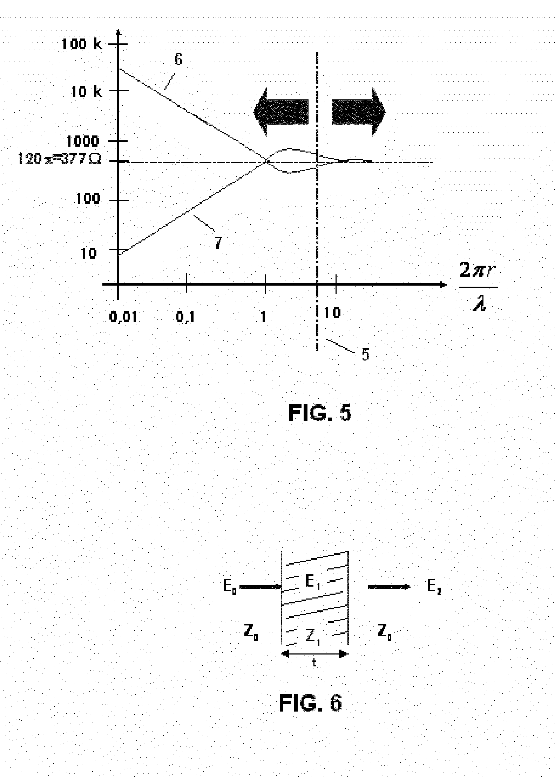

Reported in the enclosed Figure 5 is the impedance $Z_0$ of the electric dipole and the magnetic dipole with the variation of the distance from the dipole itself. The vertical dashed line "5" indicates the separation between "far field" and "near field".

In Figure 5: 6 = curve of the electric dipole; 7 = curve of the magnetic dipole.

In the far field case, the efficiency will be the same independent of the type of source of the disturbance.

However, in the case of near field, the efficiency values are quite different since the reflection coefficient changes as a function of the type of disturbance, becoming small in the case of disturbance comparable to a magnetic dipole.

The second impedance that comes into play in calculating the reflection coefficient is that of the material constituting the shield.

For a generic material with losses of dielectric type:

$$Z_1 = \sqrt{\frac{\mu_0}{\varepsilon_0}}\sqrt{\frac{\mu_r}{\varepsilon_r}} = \sqrt{\frac{\mu_0}{\varepsilon_0}}\sqrt{\frac{\mu_r}{\varepsilon'-j\varepsilon''}} = \sqrt{\frac{j\omega\mu}{\sigma+j\omega\varepsilon}}$$

It is observed that the reflection is greater the higher the impedance jump between the two materials.

**Losses by reflection for electric fields**

If the shielding material is a metal, then in far field situation the reflection coefficient is very close to 1, since the incident wave impedance is approximately 377 $\Omega$ whereas that of the metal is on the order of thousandths of $\Omega$.
When instead the shield is in a near field situation, because it is physically adjacent to the source or when the irradiated signal has a much greater wavelength (low frequencies), the efficiencies of the shield depend on the source:

- If it is of electric type, then the wave impedance tends to increase with the decrease of the distance and consequently the shielding further improves;
- If it is of magnetic type, however, the impedance tends to be canceled, considerably reducing the impedance jump between the two materials and thus the efficiency of the shield.

Starting from the abovementioned qualitative aspects, we will now seek to provide a quantitative aspect.
For the sake of simplicity, the air-metal-air interface of Fig. 6 is considered.
First, the air-metal interface is considered; assuming that the electric field hits the shield in perpendicular direction (worst case), a reflected wave and a wave transmitted inside the metal will be obtained, whose value can be calculated once the wave impedances $Z_0$ and $Z_1$ are known.
The wave transmitted inside the metal is

$$E_1 = \frac{2Z_1}{Z_0 + Z_1} E_0$$

If the shield is effective, this value is much lower than $E_0$ since nearly the entire field would have been reflected.
Once the metal interior has been reached, the wave continues to propagate, even if it is attenuated due to skin effect. Ignoring the skin effect, when the wave exits from the conductor of the shield, it will undergo a new impedance jump with the consequent production of a further pair of reflected and transmitted waves.
The wave that exits from the shield can thus be represented as:

$$E_2 = \frac{2Z_0}{Z_1 + Z_0} E_1 = \frac{2Z_0}{Z_1 + Z_0}\frac{2Z_1}{Z_0 + Z_1} E_0 = \frac{4Z_0 Z_1}{(Z_1 + Z_0)^2} E_0$$

Assuming that the impedance of the metal is much less than the impedance of the wave in vacuum, $Z_1 << Z_0$, the preceding equation is simplified and becomes:

$$E_2 = \frac{4Z_1}{Z_0} E_0$$

From the latter, one can calculate the coefficient of absorption via reflection expressed in dB:

$$R_E = 20 Log\left(\frac{E_0}{E_2}\right) = 20 Log\left(\frac{Z_0}{4Z_1}\right)$$

From the $R_E$ equation, and from the general S equation, it is confirmed that the efficiency of the shield increases with the decrease of $Z_1$ with respect to $Z_0$; hence, in this case, different with regard to the losses by absorption, the efficiency of the shield improves if it is made with materials with greater electrical conductivity.

With the increase of the frequency, it can be observed that the impedance of the metal increases.

$$|Z_1| = \left|\sqrt{\frac{j\omega\mu}{\sigma}}\right| = \sqrt{\frac{\omega\mu}{\sigma}} \rightarrow << 377$$

Consequently, the shielding efficiency, due to the losses by reflection, decreases at high frequencies, whereas the losses by absorption increase.

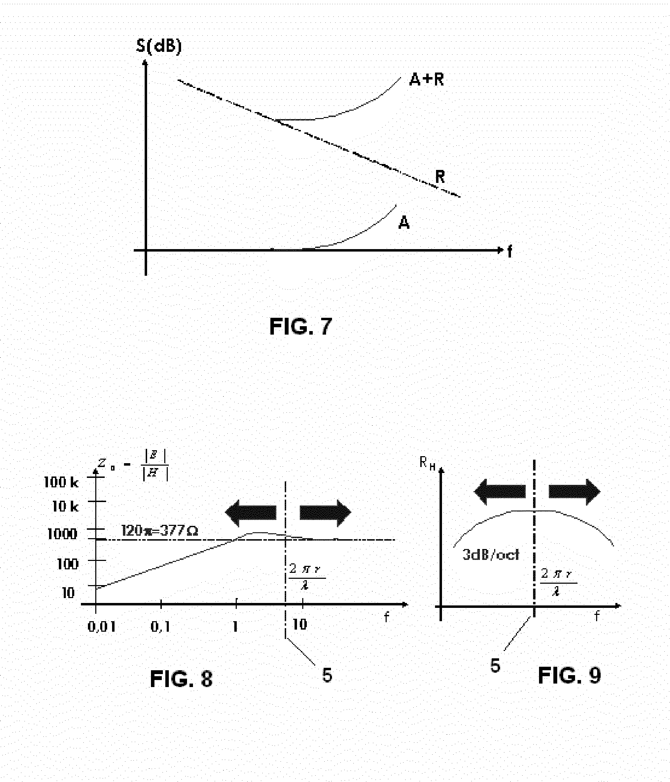

The total shielding efficiency for the electric fields is obtained by summing the coefficients of attenuation via reflection and via absorption at the various frequencies, obtaining the qualitative graph of Fig. 7, enclosed with the present application.

Since the losses by absorption depend on the thickness of the shield, the efficiency diagram will have a minimum value at a certain frequency, which will vary with the thickness of the shield itself. Clearly, for very thin shields, the main coupling mechanism up to very high frequencies on the order of 100-1000 MHz will be the loss by reflection, whereas for thick shields, the absorption has a more significant impact. In any case, it can be experimentally and analytically verified that the efficiency of a metal shield with respect to the electric fields never falls below 100 dB.

If a conductor material is used as shield, then the most appropriate shield type is selected as a function of the type of source that one wishes to shield.

For a plane wave (far source), the reflected wave is proportional to the impedance jump $Z_1$-$Z_0$ as in a line.

For a plane wave, the ratio E/H, which in vacuum equals about 377 $\Omega$, falls to 0.014 $\Omega$ if there is the metal, and the reflection coefficient is nearly 1, i.e. nearly the entire wave is reflected.

For such reason, if one must protect from a wave coming from far away, it is not worth the effort to make large shields: an aluminum sheet will suffice, since it has a very low impedance, and the wave that comes from far away - upon encountering an impedance jump - is nearly completely reflected. The thickness of the shield in this case does not have much effect: it is important that there be the largest possible impedance jump.

For a close disturbance source (close source), such as a Personal Computer, an electromechanical system placed nearby etc., we are not in far field conditions.

For such source type, the only important effect to consider is the skin effect.

The skin effect however assumes large shields (higher thickness) made with ferromagnetic materials.

**Losses by reflection for magnetic fields**

In the far field case, the same conclusions seen for the electric field are reached:

$$R_H = 20 Log\left(\frac{Z_0}{4Z_1}\right)$$

If instead the shield is found in near field conditions (such as in the case of low frequency signals), then $Z_0$ tends to cancel out, and consequently also the reflection tends to cancel out (Fig. 8).

Therefore, it is of fundamental importance to be able to determine the correct distance of the shield from the source, in a manner so as to make the latter fall within a far field zone; committing errors with this evaluation can give rise to shields with effective attenuation of several dB, against an estimated reflection of 100 dB and beyond, with considerable consequences regarding compatibility.

If for some reason it is not easy to estimate the correct distance or if this is excessive (for example, for a 100 Hz magnetic field emitted by the transformers present in linear power supplies, the distance of separation between near and far field is c/f = 3000 km), it is worth designing the shield while considering only the losses by absorption; this involves, however, the obtainment of heavy shields.

The wave impedance increases in frequency until it reaches the value of 377 Ω, while the impedance of the metal increases with the frequency; consequently, $R_H$ will have an initially increasing progression before descending at high frequencies (Fig. 9).

Description of the invention and objects thereof

From that stated above, it can be observed that the containment of conducted or radiated electromagnetic emissions depends only in part on the nature of the container containing radiating electromechanical or electronic equipment. This essentially depends on the type of connections required by the equipment and on the geometry of possible holes for the cooling of the equipment inside the container.

Based on the above, therefore, it is inferred that also in order to adhere to the most widespread laws on the shielding of electromagnetic emissions generated by electronic or electromechanical equipment, a carbon fiber laminate will suffice with a simple plate of thin thickness placed inside the box. Such plate of metal material has a double function: to make the container conductive, and thus place every single internal component at the same potential, as well as to act as an electromagnetic shield.

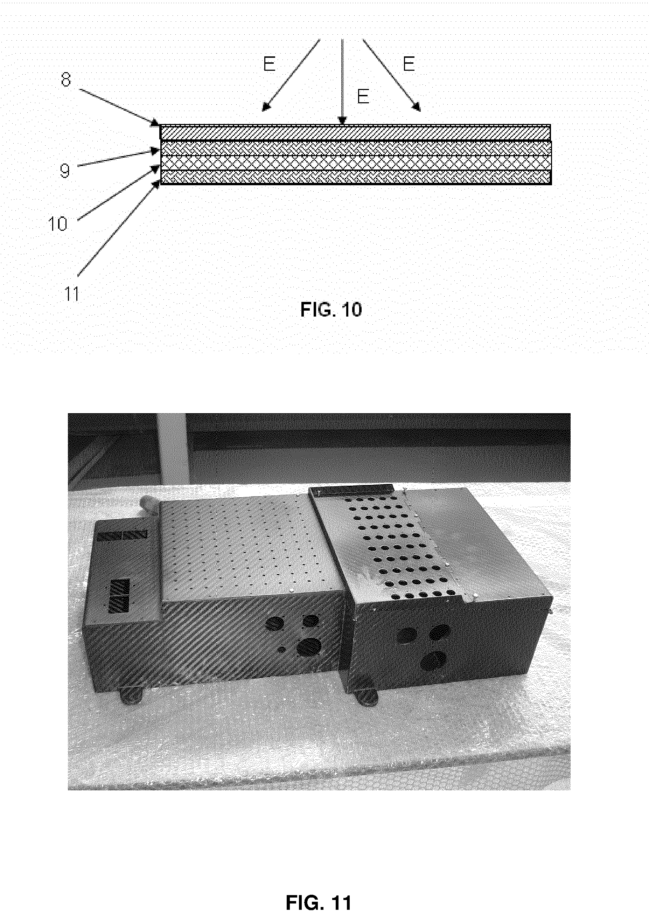

In detail, Fig. 10 illustrates a possible embodiment of the present invention, and specifically the section of the wall of the shield formed by the containment box (for electronic equipment) of the present invention, in this particular embodiment. The wall of the box/container comprises on the internal side of the box/container - on which the electromagnetic radiation energy "E" is incident on this composite material -, a metal plate, preferably made of aluminum alloy, with thickness for example equal to 1/10 mm. The aluminum alloy is preferable since it is lighter and shields sufficiently. The subsequent layer 9 is made of carbon fiber. Preferably, this is in resin resistant to not-overly-high temperatures (constituting the matrix) which impregnates long carbon fibers. The layer 10, placed near the latter carbon fiber layer 9, is formed by a core 10, which can be a honeycomb of aluminum alloy, aramid paper or steel alloy, or alternatively a carbon-based foam. The external layer 11 of the container is a carbon fiber layer, but with a different matrix, in a resin resistant to rather high temperatures. Generally, each layer has to accomplish particular tasks. The layer constituting the core 10 could for example be omitted in an embodiment of "solid" type. In an embodiment of "sandwich" type, the layer 10 will instead be inserted (its low thermal conductivity serves as thermal insulation and protection for the equipment housed in the box). In any case, the shielding with the metal film, preferably aluminum, must always be provided, whether the container (box) is "sandwich" or "solid", since the very presence of the electronic or electromechanical equipment residing therein requires it, as results from the above-detailed discussion.

The box could also provide for a solid cover and a remaining sandwich part (see Fig. 11, Distribution Box of an UAV aircraft).

The particular design selection depends on the inertial or thermomechanical loads to which the container is subjected. On board an airplane, or a helicopter, with accelerations equal to 8 g, the masses inside the container stress its structure to an extent equal to 8 times their weight; moreover, if the temperature dissipated by the internal components reaches 120°C, there is a further negative impact on the mechanical characteristics. Hence, overall, the factors that determine sizing will be the set of thermal, inertial and mechanical loads.

The container for electronic or electromechanical equipment made of carbon fiber with nanostructured matrix presents innovative features with regard to the materials and their functionalities.

Materials: Matrices, fibers, foam and honeycomb

**Matrices**

The matrices which impregnate the long fibers and which have the functionality of transferring the loads from one fiber to another, to ensure the shape of the manufactured article, can be of phenol, epoxy or bismaldehyde type. The phenols are used when the operating temperatures are extremely high, and they can be considered as a sizing load in the mechanical-thermal analysis: the phenol resins have the particular characteristic of having a very high percentage of carbon therein and a limited quantity of accessory elements that - pyrolized with suitable thermal cycles in inert gases - render such matrices usable even at temperatures up to 600°C. In addition, the phenol matrices, given their low viscosity and their consequent high impregnation capacity, accept the nanostructuring in an optimal manner, i.e. they behave like isotropic colloidal solutions when they are loaded with nanoparticles, in the specific case beta SiC.

The epoxies are used when the temperatures do not exceed 150-200°C and they have the particular characteristic of having high mechanical characteristics. Sometimes, in order to defend the internal equipment from high operating temperatures and equally high inertial loads, it might occur that the container is made by means of a sandwich

7

which provides the skins in contact with high external temperature, due to phenol matrices, a core made of carbon foam with low thermal conductivity that has the double function of increasing the moment of inertia of the container and shielding the internal part from the high temperatures; the internal skin, however, in order to handle inertial loads, is in epoxy resin with high mechanical characteristics.

The bismaldehyde-based resins are used when the inertial loads are of average nature and the operating temperatures do not exceed 240°C. Indeed, such matrices have good mechanical characteristics, not comparable to those of the epoxies, and good characteristics of resistance to high temperature, even if not comparable to those of the phenols. Regarding the possibility of nanostructuring epoxy resins as with the phenol resins, this is possible but to a lower extent than with the phenols and for the obtainment of different results: by bringing the nanoparticles of beta SiC inside an epoxy resin, the result that is obtained is a deterioration of the mechanical characteristics of the matrix in favor of an improved resistance to oxidation of the same. The bismaldehyde-based resins do not readily accept the carbon load used and thus are not nanostructured.

**Fibers**

The long fiber used is the carbon fiber, which has the maximum thermal conductivity among the flexible fibers of organic character, deriving from PolyAcryloNitrile (PAN) or from pitch. Such fiber, present on the market in various formats and with various characteristics, has very high mechanical characteristics in relation to weight and high resistance to oxidizing and reducing environments and above all to high temperatures; the fiber is the reinforcement unequivocally selected for making such containers.

**Core**

Two types are used: Honeycombs of aluminum alloy, aramid paper or steel alloy, or a carbon-based foam. The selection occurs as a function of the operating temperature and the weight that one wishes to reach, and on the inertial loads to which the present container is subjected.

Among the advantages offered by the container of the present invention, there is the fact that its weight is 50% less than that of current containers made of materials such as aluminum alloy or steel alloy.

In order to have an electromagnetic performance equal to or greater than that obtainable with conventional materials, the containers of the present invention have a metal film 8 of thin thickness, preferably made of aluminum. By arranging it inside the container, the metal film 8 also has the function (see above) of placing the electronic or electromechanical equipment at the same potential. Such film 8, together with the characteristics of the carbon fiber laminate with nanostructured matrix, contributes in an important manner to containing the electromagnetic emissions generated inside the box by the electronic or electromechanical equipment inserted therein.

The container of the present invention could have any one shape, suitable for the purpose and for the place of installation. It can constitute a solid or sandwich laminate with carbon fiber with nanostructured matrix. The resin constituting the matrix can be phenol, epoxy or bismaldehyde resin, in quantities necessary for satisfactorily resisting the set of loads to which the container is subjected.

The cores 10, in the case of the laminate sandwich, can be made of aluminum, steel and aramid paper honeycomb, or carbon foam, if the container must have operating temperatures greater than 350°C. The percentage of nanoparticles of beta SiC type can vary from a minimum of 2% to a maximum of 40% with respect to the matrix, as a function of the container's fire resistance.

**Claims**

1. A container made of carbon fiber for electronic or electromechanical equipment, for aeronautical and/or military use, **characterized in that** it comprises a laminate (8, 9, 10, 11) with layers of carbon fiber with thermosetting matrices, whose internal layer (8) - which faces the electronic or electromechanical equipment - is formed by a metal electromagnetic shielding film (8).

2. A container according to claim 1, **characterized in that** said metal electromagnetic shielding film (8) is made of aluminum alloy and has a substantially constant thickness.

3. A container according to claim 1 or 2, **characterized in that** said metal electromagnetic shielding film (8) has a thickness of about 1/10 mm at most.

4. A container according to claim 1, **characterized in that** the metal film (8) is made of steel or iron and has a substantially constant thickness of about 0.01 mm.

5. A container according to any one of the preceding claims, **characterized in that** depending on the thermo-mechanical loads to which the container will be subjected, and depending on the protection from oxidation and from fire that one desires to have, thermosetting matrices in phenol resin and/or epoxy resin and/or bismaldehyde-based resin are used for impregnating said carbon fibers.

6. A container according to claim 5, **characterized in that** at least one of said thermosetting resins is nanostructured with beta SiC.

7. A container according to claim 6, **characterized in that** the percentage of nanoparticles of beta SiC type varies from a minimum of 2% to a maximum of 40% with respect to the matrix.

8. A container according to any one of the preceding claims, **characterized in that** it comprises at least one core (10), made of carbon foam with low thermal conductivity and/or honeycombs of aluminum alloy and/or aramid paper and/or steel alloy.

9. A container according to any one of the preceding claims, **characterized in that** it comprises an external layer (11) of the wall of the container, which is made with carbon fibers in a phenol resin matrix.

10. Use of a container according to any one of the preceding claims, on fixed wing or rotary wing aircraft, ship units, tanks, simple troop transport vehicles, and in Formula 1 competitions.

11. Use of a container according to the preceding claim 10, wherein the inertial loads to which the container is subjected can reach 8 g and the container can be exposed to temperatures up to 600°C.

12. A container according to any one of the preceding claims 1 - 9, **characterized in that** it comprises, in a specific embodiment, an internal film (8) made of aluminum alloy, a first intermediate layer (9) made of carbon fiber, a core (10), and finally a second external layer (11) made of carbon fiber, the latter preferably comprising a phenol resin matrix, as resins for impregnating said carbon fibers.

13. A container according to any one of the preceding claims 2 - 9 or 12, **characterized in that** said internal metal film (8), made of aluminum alloy, maintains at the same electric potential all of the electronic or electromechanical equipment that is housed inside the container.

**FIG. 1**

**FIG. 2**

FIG. 3

FIG. 4

FIG. 5

FIG. 6

**FIG. 7**

**FIG. 8**

**FIG. 9**

FIG. 10

FIG. 11

Europäisches
Patentamt
European
Patent Office
Office européen
des brevets

**EUROPEAN SEARCH REPORT**

Application Number

EP 12 15 3632

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 164 542 A (HART WILLIAM [US]) 17 November 1992 (1992-11-17) * column 11, line 50 - column 14, line 7; claims 1-7; figure 15 * | 1-13 | INV. H05K9/00 |
| X | FR 2 910 226 A1 (TRIXELL SAS SOC PAR ACTIONS SI [FR]) 20 June 2008 (2008-06-20) * page 3, line 30 - page 7, line 8; claims 1-4; figure 2 * | 1-7, 9-11,13 | |
| A | US 6 399 903 B1 (STEVENSON JAMES F [US]) 4 June 2002 (2002-06-04) * the whole document * | 1-13 | |
| A | GB 2 114 981 A (PLESSEY CO PLC) 1 September 1983 (1983-09-01) * the whole document * | 1-13 | |
| A | WO 2008/074735 A2 (UFI FILTERS SPA [IT]; GIRONDI GIORGIO [IT]) 26 June 2008 (2008-06-26) * the whole document * | 1-13 | TECHNICAL FIELDS SEARCHED (IPC) H05K |

The present search report has been drawn up for all claims

| Place of search | Date of completion of the search | Examiner |
|---|---|---|
| The Hague | 12 June 2012 | Kaluza, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 12 15 3632

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2012

| Patent document cited in search report | | Publication date | Patent family member(s) | | Publication date |
|---|---|---|---|---|---|
| US 5164542 | A | 17-11-1992 | NONE | | |
| FR 2910226 | A1 | 20-06-2008 | NONE | | |
| US 6399903 | B1 | 04-06-2002 | AU | 3862600 A | 21-09-2000 |
| | | | EP | 1166609 A2 | 02-01-2002 |
| | | | US | 6399903 B1 | 04-06-2002 |
| | | | WO | 0052982 A2 | 08-09-2000 |
| GB 2114981 | A | 01-09-1983 | NONE | | |
| WO 2008074735 | A2 | 26-06-2008 | NONE | | |

EPO FORM P0459

For more details about this annex : see Official Journal of the European Patent Office, No. 12/82